# EUROPEAN PATENT SPECIFICATION

(11) **EP 0 449 319 B1**
(45) Date of publication and mention of the grant of the patent: **04.10.1995**
(21) Application number: 91105092.0
(22) Date of filing: 28.03.1991
(51) Int. Cl.: H03L 7/093

(54) **Circuit for reducing microphony**
Schaltung zur Mikrofoniereduzierung
Circuit pour réduire la microphonie

(30) Priority: 29.03.1990 FI 901583
(43) Date of publication of application: 02.10.1991
(73) Proprietor: NOKIA MOBILE PHONES LTD., 24101 Salo (FI)
(72) Inventor: Jokinen, Tauno, SF-90570 Oulu (FI); Vimpari, Markku, SF-90570 Oulu (FI)
(74) Representative: Flügel, Otto, Dipl.-Ing.

(56) References cited:
- EP-A- 0 284 484
- WO-A-82/01292
- US-A- 4 752 749
- PATENT ABSTRACTS OF JAPAN vol. 13, no. 513 (E-847)(3861) November 16, 1989 & JP-A-1 208 004 (NIPPON DEMPA KOGYO CO LTD ) August 22, 1989

## Description

The invention relates to a circuit for reducing microphony which includes ceramic surface-mounted capacitors.

In recent years the use of surface-mounted components in electronic circuits has become more common. Such a construction has a number of advantages, but particularly in connection with ceramic surface-mounted capacitors there has been the disadvantage of interference voltage caused by microphony. Such microphony is especially detrimental, for example, in the filter circuits of a radio telephone and in a voltage-controlled oscillator.

Microphony of a ceramic capacitor means that the voltage between the capacitor terminals changes under mechanical action. The mechanical action may consist of impacts or vibration, causing deformation of the capacitor and appearing, for example, in a radio telephone which is portable or installed in an automobile. Efforts have been made to reduce microphony by placing the critical capacitors in a location where their fastening is as firm as possible, i.e. where their deformation is minimal. Special attention must also be paid to the fastening of the printed circuit board which serves as the substrate for the surface-mounted capacitor.

Such an approach in accordance with the state of the art produces problems in circuit design, since it substantially restricts the locating of the components and/or increases the costs of mechanical installations.

A mechanical radio receiver tuner with microphonics elimination circuitry is for example known from WO 82/01292. During a mechanical tuning mode, the mechanical position of a movable tuning element provides an associated adjustable reactance which determines a control voltage for controlling the output of a voltage controlled oscillator that serves as the local oscillator for a superheterodyne radio receiver. After initially selecting a channel frequency by adjusting the output of the voltage controlled oscillator with the mechanically movable tuning element in the tuning mode, a switch disconnects the movable tuning element from operative control of the local oscillator frequency and implement as a locked tuning mode by providing the voltage controlled oscillator with a control voltage related to the difference between the frequency of the output signal of a mixer stage and the center frequency of a fixed tuned narrow passband IF stage that follows the mixer. When substantial changes in the reactance providing by the movable tuning element are sensed, the switching circuit reimplements the tuning mode so that the position of the mechanically movable element will once again control the output of the local oscillator. In this manner, minor changes in the mechanical position of the movable tuning element during the locked tuning mode have no effect on receiver tuning and therefore microphonics are substantially eliminated.

The object of the invention is thus to find for the problem a new solution by which the effects of the microphony of ceramic surface-mounted capacitors are reduced. A circuit is presented in Claim 1 as a solution to this problem. If the direct voltage effective across the capacitor is eliminated, microphony does not substantially cause non-desirable interference voltage. Embodiments of the invention are presented in the non-independent claims.

The invention is described below with the help of embodiment examples, more precisely a loop filter of the frequency synthesizer of a radio telephone, with reference to the accompanying drawing, in which:
Figure 1 is the circuit diagram of one prior-art frequency synthesizer;
Figure 2 is a photograph of an oscilloscope display, depicting a comparison of the interference voltages in an impact test with a capacitor having conventional circuitry and a capacitor having circuitry according to the invention and no direct-voltage component across the capacitor; and
Figures 3 - 5 depict circuits according to the invention, fitted in a loop filter of a synthesizer according to Figure 1.

In a phase-locked frequency synthesizer the loop filter is a filter coupled between the phase comparator and the VCO, here a second-degree active filter by means of which the operating parameters of the loop are determined at the frequency and time levels (e.g. settling time, modulation response). The loop filter functions within the audio frequency range, the typical cut-off frequency of the low-pass stage being approx. 200 Hertz. With practical component values, this usually leads to the use of components in an order of magnitude of 10 - 47 nF. Implemented by the surface-mounting technique, ceramic components of this magnitude are quite microphonic. Passive-stage capacitors connected after the active loop filter are particularly prone to develop microphony, since even an interference voltage of 1 millivolt in the VCO control line corresponds the highest possible speech volume as the modulation of the transmission signal of a mobile telephone.

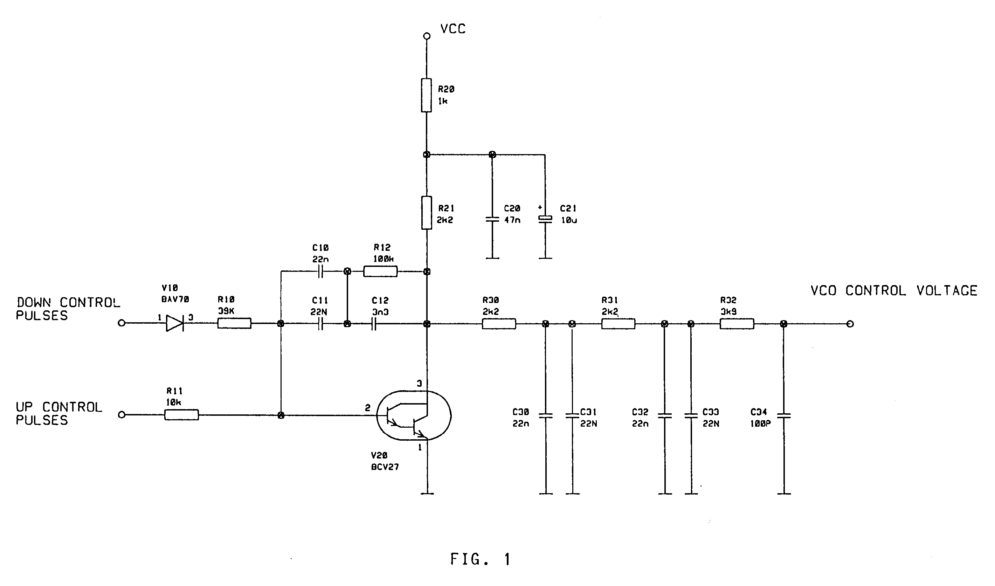

Figure 1 depicts the circuit diagram of the loop filter of the frequency synthesizer used in a radio telephone. This circuit has been implemented using surface-mounted components. In the loop filter the ceramic surface-mounted capacitors C30 - C33 (22 nF) to the right of the transistor pair V20 are coupled between the signal lead and the ground. When the circuit board is subjected to an impact, owing to the microphony of the capacitors an interference voltage with a strongly varying amplitude is produced in the circuit (in the output VCO Control Voltage).

The invention is based on an idea model of the production of a non-desirable, i.e. interference voltage: when a capacitor is bent mechanically, its capacitance value changes. Since the electric charge of the capacitor remains unchanged (electrons do not disappear), from this follows between the capacitor terminals a voltage change proportional to the change in the component value, i.e. the capacitance.

The interference voltage is due to the change in the capacitance value, and it can be expressed roughly with the formula:$\text{interference voltage = (change in capacitance) x (voltage effective across the capacitor)}$

From this it is observed that the generation of an interference voltage can be prevented substantially by eliminating the voltage (direct voltage) effective across the capacitor.

In order to ascertain this observation, an experiment was performed using two surface-mounted capacitors in a circuit on a printed circuit board. One of them had been coupled in the manner shown in Figure 1, so that there was a direct voltage effective across it. The voltage changes of the capacitor were strongly amplified, and the amplified signal was measured in one of the channels of a memory oscilloscope. To the other channel there was coupled a capacitor across which there was, in accordance with the invention, no direct-voltage component. By striking the printed circuit board, an easily detectable impact response was obtained.

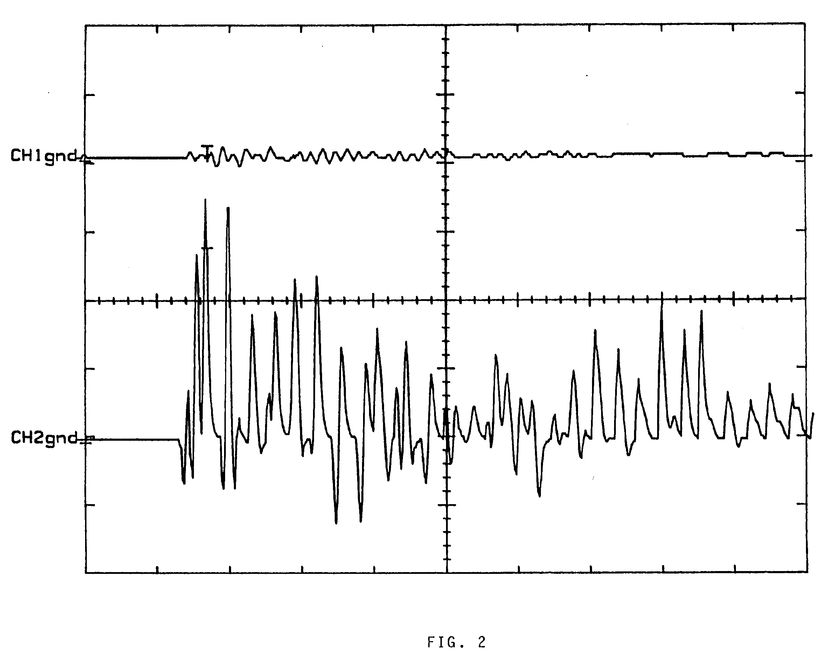

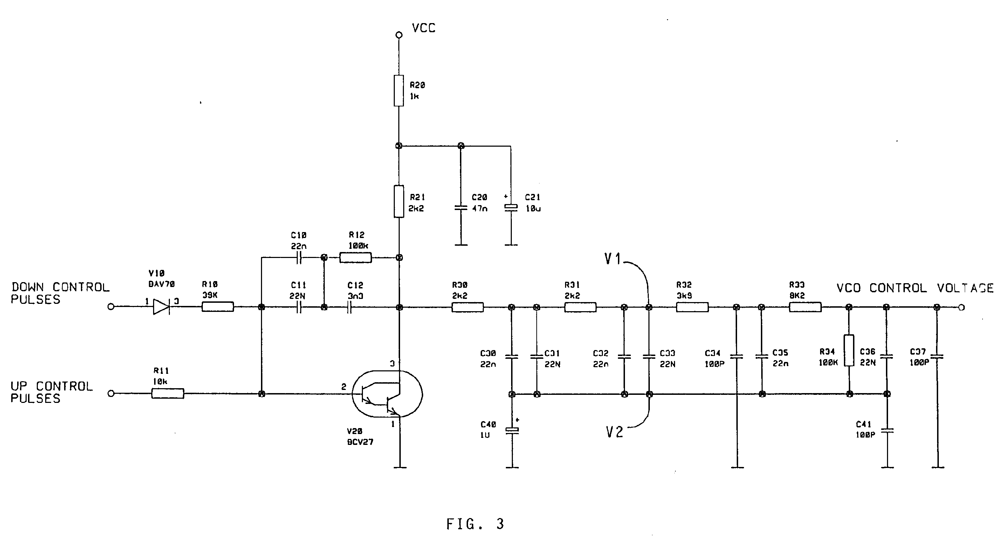

Figure 2 depicts an oscillogram which shows the strong impact response (oscillation of the voltage) of the capacitor. Channel 2 (indicated by CH2 gnd) has the interference voltage caused by the capacitor coupled according to the principle of Figure 1, and channel 1 (indicated by CH1 gnd) has the interference voltage caused by the ceramic piece capacitor (e.g. C30) which is coupled according to the principle of Figure 3 described below, i.e. it is compensated. In both cases the oscilloscope settings and test coupling amplifications were fully identical. Thus the effect of the invention was verified, i.e. the reduction of the interference voltage, even to the extent that the arrangement according to the invention can be deemed to prevent substantially the production of an interference voltage due to capacitor microphony.

At the same time it was observed that the tantalum capacitor used in the experiment did not, upon an impact, cause an interference voltage typical of a ceramic capacitor.

A method for reducing microphony can be implemented by arranging a circuit according to the invention which eliminates the direct voltage effective across ceramic capacitors. The loop filter circuit of Figure 1 is used as an example. As the first step, the signal ground of the capacitors was separated from the actual ground potential by means of a tantalum capacitor. Figure 3 depicts a circuit like this, with a tantalum capacitor C40 (1 µF).

In Figures 3 - 5 the direct voltage of the signal lead is indicated by V1 and the and direct voltage potential of the signal ground by V2.

In the loop filter in Figure 3, microphony may appear on the ceramic capacitors C30 - C36 (22 nF). The direct voltage differential effective across them is eliminated by means of a resistance R34 (100 kohm) so that V1 = V2.

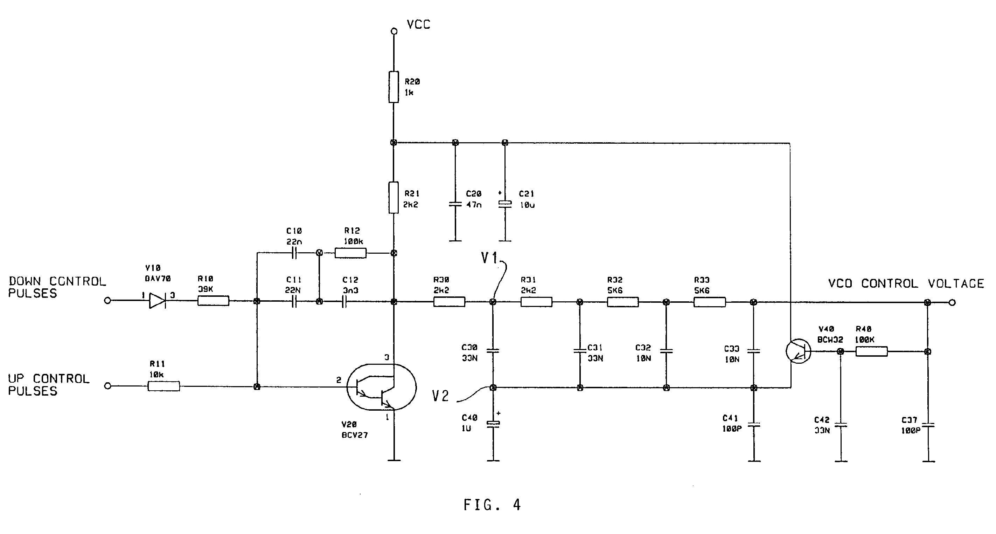

In the loop filter in Figure 4, there are ceramic capacitors C30 - C33 (values 33 nF, 10 nF) and also a tantalum capacitor C40 (1 µF); in this circuit the direct-voltage differential V1-V2 is eliminated by means of a transistor V40.

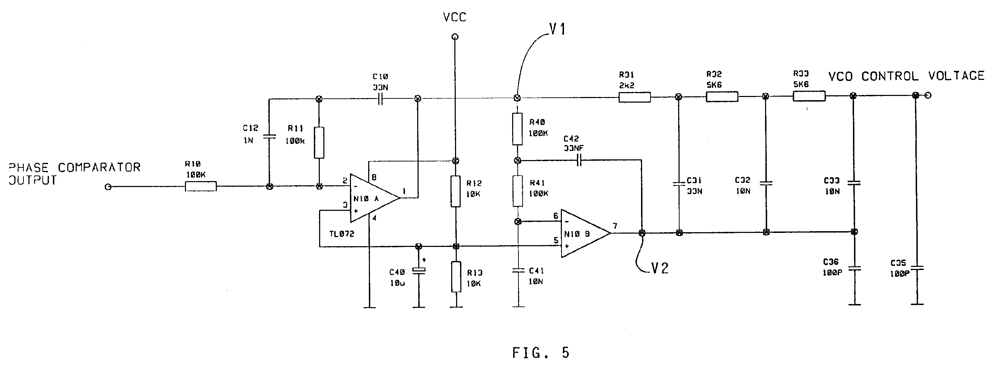

Figure 5 finally depicts a loop filter implemented using operational amplifiers. The operational amplifiers N10A and N10B are coupled in such a manner that they actively cancel any possible direct-voltage differential V1-V2. The apparent ground potential is formed by a tantalum capacitor C40 (10 µF).

A comparison of Figures 3 - 5 to the loop filter according to Figure 1 shows that they have certain additional components due to practical circuit design. The components essential from the viewpoint of the invention were mentioned above in connection with the figures. It is hardly necessary to describe the operation of the circuits of Figures 1, 3 - 5 in greater detail in this context, since it is evident for an expert in the art and does not as such relate to the application of the invention.

In the experiments carried out it was observed that by using the circuit arrangement according to the invention the interference voltage caused by a ceramic surface-mounted capacitor can be reduced in a precisely predictable manner by 20 - 40 dB, in which case the elimination of the direct voltage from the ceramic capacitor means that such a capacitor will not be a factor affecting the total microphony of a radio telephone.

The described loop filter of a frequency synthesizer is only one example of the circuits which according to the invention can be applied for reducing microphony.

## Claims

1. A circuit for reducing microphony in a filter circuit having ceramic surface-mounted capacitors (C30-C36), each capacitor having two terminals, comprising:
a signal lead connected to one terminal of each capacitor;
a signal ground connected to the other terminal of each capacitor; and
circuit component means (R34; V40; N10A, N10B) connected to the capacitors for eliminating d.c. potential differences between the signal lead and the signal ground.

2. The circuit of claim 1, wherein the circuit component means includes a resistor (R34) in parallel connection with the capacitor.

3. The circuit of claim 1, wherein the circuit component means includes a transistor (V40) coupled as a high-impedance component between the signal lead and the signal ground.

4. The circuit of claim 1, wherein the circuit component means includes at least one operational amplifier (N10A/B) which adjusts the direct-voltage potential (V1) of the signal ground.

5. The circuit of claim 1, wherein the circuit is used in a portable data communication apparatus.

6. The circuit of claim 5, wherein the data communication circuit is a radio telephone.

7. The circuit of claim 1, wherein the circuit is a filter located between a voltage controlled oscillator and a phase comparator of a phase-locked loop.

## Patentansprüche

1. Schaltung zum Reduzieren des Mikrophoneffekts in einem Siebkreis mit keramischen, oberflächenmontierten Kondensatoren (C30 - C36), deren jeder zwei Anschlüsse hat, umfassend:
eine mit einem Anschluß eines jeden Kondensators verbundene Signalleitung;
eine mit dem anderen Anschluß des Kondensators verbundene Betriebserde und
ein mit den Kondensatoren verbundenes Schaltmittel (R34;V40; N1OA, N1OB) zur Eliminierung von D.C.-Spannungsunterschieden zwischen der Signalleitung und der Betriebserde.

2. Schaltung nach Anspruch 1, bei welcher das Schaltmittel einen Widerstand (R34) enthält, der mit dem Kondensator parallelgeschaltet ist.

3. Schaltung nach Anspruch 1, bei welcher das Schaltmittel einen Transistor (V40) enthält, der als hochohmiges Bauteil zwischen der Signalleitung und der Betriebserde gekoppelt ist.

4. Schaltung nach Anspruch 1, bei welcher das Schaltmittel zumindest einen Operationsverstärker (N10A/B) enthält, der das Gleichspannungspotential (V1) der Betriebserde einstellt.

5. Schaltung nach Anspruch 1, die in einer tragbaren Datenkommunikationsvorrichtung verwendet wird.

6. Schaltung nach Anspruch 5, bei welcher die Datenkommunikationsschaltung ein Funktelefon ist.

7. Schaltung nach Anspruch 1, die ein zwischen einem spannungsgesteuerten Oszillator und einem Phasenkomparator eines Phasenregelkreises angeordnetes Filter ist.

## Revendications

1. Circuit pour réduire l'effet microphonique dans un circuit filtre ayant des condensateurs céramiques montés en surface (C30 - C36), chacun des condensateurs ayant deux terminaux, comprenant:
une ligne de signalisation reliée à l'un des terminaux du chacun des condensateurs;
une terre de service reliée à l'autre des terminaux du chacun des condensateurs;
et un moyen composant circuit (R34;V40;N10A,N10B) relié aux condensateurs pour éliminer des différences de tension de courant continu entre la ligne de signalisation et la terre de service.

2. Circuit selon la revendication 1, dans lequel le moyen composant circuit comprend une résistance (R34) connectée en parallèle avec le condensateur.

3. Circuit selon la revendication 1, dans lequel le moyen composant circuit comprend un transistor (V40) couplé comme un composant à haute résistance entre la ligne de signalisation et la terre de service.

4. Circuit selon la revendication 1, dans lequel le moyen composant circuit comprend au moins un amplificateur opérationnel (N10A/B) ajustant le potentiel de tension continue (V1) de la terre de service.

5. Circuit selon la revendication 1, dans lequel le circuit est utilisé dans un appareil portable de communication des données.

6. Circuit selon la revendication 5, dans lequel le circuit de communication des données est un radiotéléphone.

7. Circuit selon la revendication 1, dans lequel le circuit est un filtre placé entre d'un oscillateur à commande par tension et un comparateur de phase d'une boucle à verrouillage de phase.
